# EUROPÄISCHE PATENTSCHRIFT

(11) **EP 4 034 975 B1**
(45) Veröffentlichungstag und Bekanntmachung des Hinweises auf die Patenterteilung: **25.10.2023**
(21) Anmeldenummer: 20776125.5
(22) Anmeldetag: 21.09.2020
(51) Int. Cl.: H10K 59/60, G06F 3/041, G06F 3/042

(54) **ANZEIGEVORRICHTUNG MIT INTEGRIERTER, OPTISCH ARBEITENDER NÄHERUNGSSENSORIK**
DISPLAY DEVICE HAVING INTEGRATED, OPTICALLY OPERATING PROXIMITY SENSOR SYSTEM
DISPOSITIF D'AFFICHAGE AYANT UN SYSTÈME DE CAPTEUR DE PROXIMITÉ À FONCTIONNEMENT OPTIQUE INTÉGRÉ

(30) Priorität: 24.09.2019 DE 102019125671
(43) Veröffentlichungstag der Anmeldung: 03.08.2022
(73) Patentinhaber: Behr-Hella Thermocontrol GmbH, 59557 Lippstadt (DE)
(72) Erfinder: SANCHEZ CASTILLO, Alberto, 59597 Erwitte (DE); SCHWAB, Tobias, 2504 Biel (CH); HOFMAN, Willem, 59597 Erwitte (DE); WU, Jeah-Sheng, Hsinchu City (TW); SCHMIDT, Rüdiger, 33100 Paderborn (DE)
(74) Vertreter: dompatent von Kreisler Selting Werner - Partnerschaft von Patent- und Rechtsanwälten mbB
(86) Internationale Anmeldenummer: PCT/EP2020/076308
(87) Internationale Veröffentlichungsnummer: WO 2021/058436

(56) Entgegenhaltungen:
- EP-A1- 3 334 130
- US-A1- 2011 221 705
- US-A1- 2014 098 058

## Beschreibung

Die Erfindung betrifft eine Anzeigevorrichtung mit integrierter, optisch arbeitender Näherungssensorik zur Erkennung eines sich innerhalb eines Beobachtungsraums vor der Anzeigevorrichtung befindenden Objekts wie z.B. einer Hand oder eines Fingers einer Hand einer Person insbesondere zur Gestenerkennung und/oder Fernfeldabtastung.

### Einleitung

HMI-Produkte (Automotive Human Machine Interface) implementieren heutzutage immer komplexere Benutzereingriffe, um dem Benutzer einen hohen Komfort zu bieten. Der Hauptkommunikations- und Interaktionskanal zwischen Mensch und Fahrzeug ist die Anzeigeeinheit. In den letzten Jahrzehnten haben die Displays im Auto neue technologische Funktionen entwickelt, die das Benutzererlebnis verstärken und maximieren. Dank der neuesten technologischen Fortschritte ist es heutzutage möglich, komplexe Center Information Display (CID) zu erstellen, die akustisches Feedback, haptisches Feedback, Berührungserkennung, Lichterkennung und Gestenerkennung integrieren. Tatsächlich sind die Lösungen zur Integration der Gestenerkennung im Automobilmarkt begrenzt.

Beispiele für HMI-Produkte sind beschrieben in WO-A-2019/012046, WO-A-2014/156399, US-A-2009/0231497, US-A-2010/0220269, US-A-2011/0221705, US-A-2011/0115749, US-A-2011/0193818, US-A-2014/0098058, US-A-2014/0192023, US-A-2015/0084928, US-A-2015/0084928, US-A-2018/0069609, US-B-8 860 694, US-B-9 557 846, PCT/ EP2019/059234, DE-A-10 2016 100 363, GB-A-2 486 000, CN-Y-201383058Y, KRATZ, Sven; ROHS, Michael: Hoverflow: Exploring Around-Device Interaction with IR Distance Sensors, 11th International Conference on Human-Computer Interaction with Mobile Devices and Services, MobileHCI '09, Bonn, Germany, September 15-18, 2009, Conference Proceedings, ISBN 978-1-60558-281-8. New York: ACM, 2009. Article No. 42, KRATZ, Sven: Sensor-Based User Interface Concepts for Continuous, Around-Device and Gestural Interaction on Mobile Devices. Dissertation, Fakultät für Mathematik, Informatik und Statistik, Ludwig-Maximilians-Universität München. München: LMU, 2012, OH, KyongSae; HWANG, Seok-Hee; YOU, SeungBin et al.: Gesture Sensor for Mobile Devices - White Paper, Firmenanschrift, Samsung Electronics Co. Ltd. Suwon-si, Gyeonggi-do, KR: Samsung, 2013.

In BÜRGI, L. [u. a.]: Optical proximity and touch sensors based on monolithically integrated polymer photodiodes and polymer LEDs. In: Organic Electronics, Vol. 7, Nr. 2, 2006, S. 114-120. DOI: https://doi.org/10.1016/j.or-gel.2005.12.002. Science Direct [online] und ZHOU, X. [u. a.]: Highly Sensitive a-Si:H PIN Photodiode Gated LTPS TFT for Optical In-Display Fingerprint Identification. In: Society for Information Display International Symposium Digest of Technical Papers, Vol. 49, Nr. 1, 2018, S. 490-493. DOI: https://doi.org/10.1002/sdtp.12608. Wiley Online Library [online] sind ferner Photodioden in verschiedenen Technologien beschrieben.

Die Gesten- und Fernfelderkennung im Auto verwendet Ansätze, die hauptsächlich auf Infrarot-(IR-)Sensierung oder Kameras basieren. Bei vielen Innenarchitekturen im Fahrzeug werden die IR-Erkennungssysteme für die Gesten- und Fernfelderkennung getrennt vom Display integriert und entworfen. Andere IR-Systeme sind auf der Anzeige integriert, um nur die Berührungserkennung zu ermöglichen. Der Hauptnachteil dieser IR-Detektions-designs besteht darin, dass sie für die Integration zusätzlich zum Platzbedarf für das Display Platz im Fahrzeug benötigen. Der zukünftige Trend im Autoinnenraum geht zu ultraflachen Display-Systemen, deren Anzeigeflächen sich fast bis zum Displayrand erstrecken, also nur noch extrem schmale, nicht für die Informationsanzeige nutzbare Randbereiche aufweisen. Die Integration der aktuellen IR-basierten Systeme für CIDs und andere Anzeigeelemente im Fahrzeug macht die Realisierung eines "ultra slim border" Display-Designs somit unmöglich. Daher müssen neue Ansätze für die Integration von IR-Detektionssystemen in die Anzeigeeinheiten entwickelt werden.

Aus EP-A-3 334 130 ist eine Anzeigevorrichtung mit integrierter, optisch arbeitender Näherungssensorik zur Erkennung eines die Anzeigevorrichtung berührenden Objekt wie z.B. einer Hand oder eines Fingers einer Hand einer Person bekannt. Die bekannte Anzeigevorrichtung weist eine Anzeigeeinheit auf, die eine Vorderseite mit einer Information anzeigenden Anzeigefläche, einen an die Anzeigefläche angrenzenden, für die Anzeige von Informationen nicht verwendeten Randbereich und eine Rückseite aufweist. Ferner ist die bekannte Anzeigevorrichtung mit einer Näherungssensorik versehen, die mindestens einen Sender zum Aussenden von Sensorstrahlung in den Bereich vor der Anzeigeeinheit hinein und mit mindestens einem Empfänger zum Empfangen von reflektierter Sensorstrahlung aus diesem Bereich aufweist. Der mindestens eine Sender der Näherungssensorik ist unterhalb der Anzeigeeinheit, d.h. beispielsweise unterhalb der von der Anzeigefläche eingenommenen Region oder unterhalb des Randbereichs der Anzeigeeinheit oder an der Rückseite der Anzeigeeinheit oder der Rückseite der Anzeigeeinheit zugewandt oder in der Anzeigeeinheit angeordnet, während der mindestens eine Empfänger der Näherungssensorik in dem an die Anzeigeeinheit angrenzenden Randbereich auf der Vorderseite oder der Rückseite der Anzeigeeinheit angeordnet ist. Die Anzeigeeinheit ist als TFT-Anzeigepanel ausgebildet. Das TFT-Anzeigepanel ist mit einer die Vorderseite der Anzeigeeinheit bildenden Oberseite, die einen die Anzeigefläche bildenden Bereich mit TFT-Transistoren und einen diesen Bereich umgebenden, den Randbereich bildenden Überstandsbereich aufweist, und mit einer der Oberseite abgewandten Unterseite und einer oberhalb der oder auf der Oberseite des Anzeigepanels angeordneten Farbfilterschicht versehen. Der mindestens eine Empfänger und/oder der mindestens eine Sender der Näherungssensorik ist bzw. sind jeweils als Halbleiterdiode ausgebildet.

### Aufgabe der Erfindung

Aufgabe der Erfindung ist es, die Herstellung einer Anzeigevorrichtung mit integrierter, optisch arbeitender Näherungssensorik weiter zu verbessern und insbesondere zu vereinfachen, wobei vor allem der nicht für die Anzeige von Information verwendbare Randbereich der Anzeigevorrichtung, obwohl dieser Randbereich recht schmal ausgeführt ist, dennoch für die Unterbringung von zumindest Teilen der Näherungssensorik genutzt werden soll.

### Erfindung

Zur Lösung dieser Aufgabe wird mit der Erfindung eine Anzeigevorrichtung vorgeschlagen, die eine integrierte, optisch arbeitende Näherungssensorik zur Erkennung eines sich innerhalb eines Beobachtungsraums vor der Anzeigevorrichtung befindenden Objekts wie z.B. einer Hand oder ein Finger einer Hand einer Person zur insbesondere Gestenerkennung und/oder Fernfeldabtastung aufweist und mit den Merkmalen des Anspruchs 1 versehen ist. Einzelne Ausgestaltungen der Erfindung sind Gegenstand der abhängigen Ansprüche.

Wesensmerkmal der Erfindung ist es, zumindest Teile der Näherungssensorik, nämlich die Empfänger der Näherungssensorik, mit derjenigen Planar-Technologie auszubilden, in der auch die Standard-Dünnfilmtransistoren (TFTs) von TFT-Array-Technologie-Anzeigevorrichtungen hergestellt sind. Ein TFT-Transistor besteht aus mehreren übereinander angeordneten Halbleiter- bzw. Metallisierungsschichten, die sukzessive in Einzelschritten planar hergestellt werden.

Die erfindungsgemäß vorgesehene Näherungssensorik umfasst demzufolge Halbleiterdioden zumindest als die Empfänger, wobei mit Vorteil sogenannte PIN-Fotodioden eingesetzt werden. Diese Dioden lassen sich so wie die TFT-Transistoren in mehreren Produktionsschritten planar aufbauen. Das TFT-Array kann beispielsweise standardmäßig hergestellt sein, um dann anschließend einen weiteren Prozess zu durchlaufen, in dem wie zuvor mehrere Schichten von Halbleitermaterial neben- oder übereinander angeordnet werden, um die Dioden der Näherungssensorik, insbesondere die Fotodioden der Empfänger, zu bilden. Hierzu eignet sich zur Platzierung der ungenutzte Randbereich um die eigentliche Anzeigefläche der Anzeigeeinheit. Dabei können die Halbleiterschichten der jeweiligen Dioden über- oder auch nebeneinander angeordnet sein. Besonders platzsparend ist es, wenn die Dioden auf Schaltkreisen angeordnet sind, die der Steuerung der TFT-Transistoren und damit der Steuerung des TFT-Arrays der Anzeigevorrichtung dienen.

Mit dieser Erfindung wird also ein neues IR-Sensorsystem für Fahrzeugqualitäten vorgeschlagen, um ein "ultra slim border" Display-Design zu ermöglichen. Anders als bei aktuellen IR-Lösungen in Anzeigen und innovativ ist bei diesem Ansatz die Integration des IR-Detektionssystems in den Dummy-Pixelbereich des Displays, während das Emissions-IR-System z.B. in der Hintergrundbeleuchtung hinter der Reflektorfolie angeordnet ist. Diese beiden Faktoren sorgen dafür, dass das "ultra slim border Display" und das auf IR-Strahlung basierende System im Auto in einer gemeinsamen Einheit koexistieren. Wichtig ist, dass die Gesten- und die Fernfelderkennung nicht beeinflusst werden. Ein weiterer Vorteil besteht darin, dass dieser Konstruktionsansatz die für die Automobilstandards erforderliche Robustheit gewährt. Natürlich ist die Erfindung in erster Linie für Gesten- und Fernfelderkennungsanwendungen und nicht für die Berührungserkennung optimiert. Sensing-Funktionalitäten im Nahfeld sind jedoch auch möglich. Die Erfindung beeinflusst die optische Leistung der Anzeige nicht, was für die Erfüllung der hohen Automobilanforderungen von entscheidender Bedeutung ist. Tatsächlich schafft diese Erfindung eine nicht wahrnehmbare Implementierung der IR-Photodioden (PD) in den Anzeigebereich, wodurch eine harmonische visuelle Wahrnehmung der schwarzen Farbe im Design erzeugt wird. Für die meisten Anwendungen im Automobilinnenraum ist diese Eigenschaft ein Muss. Vorteilhaft bei diesem Vorschlag ist die hohe Kompatibilität des Designs, das mit der derzeitigen Standard-Dünnfilmtransistor-Technologie von TFT-Arrays implementiert werden soll, die in Automobilanzeigen verwendet wird. Daher ist die Lösung in Standard-Display-Serienprozessen mit hohem Durchsatz, Skalierbarkeit und Ertrag produzierbar.

### Detektionssystem

Das in dieser Erfindung vorgeschlagene Detektionssystem besteht aus z.B. IR-Fotodioden (PD), die in der TFT-Array-Ebene integriert sind und auf dem nicht leuchtenden Pixelbereich (Dummy-Pixelbereich) angeordnet sind und den aktiven Bereich der Anzeige als Teil des Sichtbereichs umgeben, was anders ist als z.B. IR-Detektoren nach dem Stand der Technik, die innerhalb des aktiven Bereichs der Anzeige angeordnet sind. Nach der Erfindung wird also der Dummy-Bereich des TFT-Panels genutzt, der dem Fahrzeugbenutzer keine Informationen anzeigt.

Es sind Konstruktionen nach dem Stand der Technik verfügbar, bei denen das Panel-Array zur Integration von IR-Berührungs- oder Fingerabdruckerkennung verwendet wird; jedoch handelt es sich um hochkomplexe IR-Sensordesignsysteme, da sie bei Anwendungen eingesetzt werden, bei denen eine Mehrfach-Fingerberührungserfassung oder eine -Fingerdrückerkennung mit einer hohen Positionsgenauigkeit und/oder einer Positionsbestimmung und mit Hochgeschwindigkeitsverarbeitung gefordert wird. Darüber hinaus sind diese Systeme für die Verarbeitung lokaler Veränderungen optimiert, die durch die Handfinger definiert werden.

Bei der Erfindung liegt der Fokus der Anwendung völlig anders. Es wird vorgeschlagen, Photodioden (PD) in das TFT-Array zu integrieren, um zumindest Teile der Sensorik für die Gesten- und Fernfelderkennung in der Anzeige zu ermöglichen. Hier kann durch Einbeziehung von IR-PD in den TFT-Dummy-Pixelbereich (nicht beleuchteter Pixelanzeigebereich) dieser Zweck gut erfüllt werden. Ein großer Vorteil dieser Integration in das Display-TFT ist, dass kein zusätzlicher Platz für die Integration der PDs erforderlich ist, wodurch das ultraflache Slim-Border-Display mit integrierter IR-Erkennung möglich wird. Da die Designs für TFT-Displays für Automobile heute ausgereift sind, ist die Herstellung zusätzlicher PD für die IR-Erfassung einfach und kompatibel mit den TFT-Produktionsprozessen. Daher kann diese Erfindung tatsächlich die Zuverlässigkeitsstandards für Kraftfahrzeuge abdecken. Natürlich kann das Erfindungsprinzip auch für andere Verbraucher- und Industrieanzeigen gut angepasst werden.

Aufgrund der hohen optischen Leistung, die für Anzeigen in Kraftfahrzeugen gefordert wird, wie z.B. hoher Kontrast und hohe Helligkeit, ist die Standardintegration von PD in die RGB-Pixel der Anzeigefläche nicht geeignet. Diese Ansätze weisen einen entscheidenden Nachteil auf, da die Gesamtdurchlässigkeit der Anzeige erheblich verringert wird und die Gesamtleuchtdichte der Anzeige (typ. 900 Cd/m2) erheblich beeinträchtigt wird. Im Gegensatz dazu wird bei dieser Erfindung die optische Leistung der Anzeige nicht durch die Fotodioden beeinflusst. Tatsächlich macht die Erfindung das Design-IR-PD-System für den Fahrzeugbenutzer praktisch unsichtbar, was heute im Automobildesign nicht erreichbar ist.

Die IR-PDs können auf dem TFT-Array als PIN-PD hergestellt und direkt mit der auf dem z.B. LCD-Panel ausgebildeten Schaltung kombiniert werden. Daher ist das elektronische Design der IR-Photodiode auch mit der Verarbeitung von a-Si- oder LTPS-TFT-Arrays kompatibel. Hier ist die Intensität des Signals und der Ort der IR-PD wichtig, um das Signal-Rausch-Verhältnis zu erhöhen. Dementsprechend kann die Empfindlichkeit der Erfassung des IR-Signals durch Erhöhen der Anzahl an IR-Emittern oder durch Erhöhen der Anzahl an IR-PD verbessert werden. Da die Spitzenerfassungswellenlänge bekannt ist (typischerweise 940 nm) und die Geometrie und Position der Anzeige im Fahrzeug möglicherweise bekannt sein kann, kann die optimale Position der PD gut bestimmt werden. Dies bietet eine große Flexibilität bei der Entwurfseffizienz in einer CID-Anwendung. Im Allgemeinen kann das Design nach dem gleichen Prinzip auf jede Anzeigegröße erweitert werden.

### Emissionssystem

Das IR-Emissionssystem ist vorteilhafterweise in eine Hintergrundbeleuchtungseinheit, ein Anzeigefeld, ein optisches Bonding, einen Luftspalt oder in eine Abdecklinse (mit oder ohne Touchpanel-TP) integriert. Die IR-Sender können in dem hinteren Teil einer herkömmlichen hintergrundbeleuchtende Hintergrundbeleuchtungseinheit (BLU) integriert sein. Hier werden die IR-Sender z.B. geometrisch hinter dem BLU-Reflektor als direkte Beleuchtungselemente konfiguriert.

Zweckmäßigerweise wird ein Reflektor (in Form z.B. einer Folie) eingesetzt, der sowohl im IR-Bereich transparent als auch im sichtbaren Bereich hochreflektierend ist. Hier besteht der Hauptzweck des Reflektors darin, die IR-Emitter hinter dem Reflektor zu verbergen, ein hohes IR-Emissionssignal aufrechtzuerhalten und die hohe optische Qualität der Anzeige zu gewährleisten, die gemäß Automobilstandards erforderlich ist. Obwohl derartige Reflektoren derzeit auf dem Markt erhältlich sind, wurde ihre Anwendung in einem Display und in der Automobilumgebung noch nicht vorgeschlagen. Tatsächlich ist die Entwicklung dieser Art von Reflektoren in Folienform für die Automobilanforderungen eigentlich unkompliziert und behindert das Anwendungsprinzip dieser Erfindung nicht. Tatsächlich kann dieses Hintergrundbeleuchtungsdesign nicht nur für Automobile, sondern auch für andere Verbraucher- und Industrieprodukte verwendet werden. (siehe auch die WO-A-2019/197525).

Es ist wichtig, dass bei der hier vorgeschlagenen IR-Konfiguration in Kombination mit dem vollständigen Anzeigestapel (einschließlich Touch-panel und Abdeckscheibe) die Gesamt-IR-Durchlässigkeit außerhalb des Wellenlängenbereichs des Lichts für die Anzeige und z.B. bei 940 nm (+/-5%-10%) liegt. Tatsächlich ermöglicht dieses IR-Signal, das von der Anzeige ausgesendet wird, die IR-Beleuchtung in Richtung des Handbenutzers, die für die Gestenerkennung und Fernfeldabtastung erforderlich ist. Die Erfindung ist jedoch nicht auf diese Wellenlänge beschränkt, da diese auf jeden Benutzerfall abgestimmt und optimiert werden kann. Die für die Anwendung erforderliche Gesamt-IR-Leistungsdichte und Lichtverteilung kann schließlich von Fall zu Fall durch die Anzahl und Position der IR-Strahler definiert werden.

Mit der Erfindung kann somit ein kundenspezifisches IR-Fernfeld über die Displayoberfläche hinaus geschaffen werden, ohne dass zusätzlicher seitlicher Raum erforderlich ist, was die Integration bei ultraflachen Display-Designs mit schmalem Rand erleichtert. Hier kann das erzeugte IR-Fernfeld gut verwendet werden, um mit einer menschlichen Hand/einem Finger in einer CID-Anwendung zu interagieren. Dies kann leicht erweitert und auf Produkte für Industrie- und Consumer-Displays angewendet werden.

Tatsächlich ermöglicht das hier vorgeschlagene Design, dass alle optischen Leistungsmerkmale wie Gleichmäßigkeit, Leuchtdichte und Farbe der BLU praktisch intakt bleiben, da lediglich der Reflektor in der Hintergrundbeleuchtungseinheit ersetzt wird. Die mechanischen Abmessungen der BLU sind somit ebenfalls nicht betroffen.

Wie bereits oben erwähnt, ist die jeweilige Halbleiterdiode zweckmäßigerweise als IR-Halbleiterdiode ausgebildet.

In weiterer vorteilhafter Ausgestaltung der Erfindung kann vorgesehen sein, dass die Halbleiterdioden der Empfänger der Näherungssensorik als PIN-Fotodioden ausgebildet sind und eine Intrinsik-Halbleiterschicht zwischen zwei entgegengesetzt dotierten Halbleiterschichten aufweisen.

Typischerweise ist das TFT-Anzeigepanel mit in TFT-Technologie ausgebildeten Schaltkreisen innerhalb des Überstands des Anzeigepanels auf dessen Ober-und/oder Unterseite versehen.

In weiterer vorteilhafter Ausgestaltung der Erfindung kann vorgesehen sein, dass die Halbleiterdioden der Empfänger und/oder die Halbleiterdiode des mindestens einen Senders der Näherungssensorik auf einer in TFT-Technologie hergestellten Isolationsschicht ausgebildet sind, die auf einem in TFT-Technologie hergestellten, im Überstand des TFT-Anzeigepanels angeordneten Schaltkreis oder Teil davon ausgebildet ist.

Bei der von dem mindestens einen Sender abgegebenen und von den Empfängern oder Näherungssensorik empfangenen Strahlung handelt es sich, wie bereits oben erwähnt, vorteilhafterweise um IR-Strahlung als Beispiel für unsichtbare Strahlung.

Die Anzeigeeinheit kann zweckmäßigerweise als LCD-Matrix-Anzeigeeinheit ausgebildet sein, wobei sich in einem allseitig abgedichteten Zwischenraum zwischen der Oberseite des Anzeigepanels und einer Abdeckscheibe ein Flüssigkristallmedium befindet.

In vorteilhafter Ausgestaltung der Erfindung kann/können der mindestens eine Sender und/oder die Empfänger mit einer Optik zur Ausrichtung der Strahlung in Richtung auf den Beobachtungsraum vor der Anzeigefläche versehen sein.

Die erfindungsgemäße Anzeigevorrichtung kann zweckmäßigerweise versehen sein mit einer nicht-optisch arbeitenden Berührungssensorik, wie z.B. eine kapazitiv, resistiv, induktiv oder auf Ultraschallbasis arbeitende Berührungssensorik.

In weiterer zweckmäßiger Weiterbildung der Erfindung weist die Berührungssensorik ein Touchpanel auf, das auf der Vorderseite der Anzeigeeinheit oder auf der Farbfilterschicht oder hinter einer vor der Anzeigeeinheit oder vor der Farbfilterschicht angeordneten Abdeckscheibe positioniert ist.

Bei Anordnung sowohl des mindestens einen Senders als auch der Empfänger der Näherungssensorik im Randbereich der Anzeigeeinheit sind der mindestens eine Sender und die Empfänger zur Vermeidung eines Übersprechens zweckmäßigerweise beide gegeneinander abgeschottet.

In weiterer alternativ möglicher Ausgestaltung der Erfindung weist die Näherungssensorik als Empfänger eine Empfänger-Matrix mit oder ohne Optik auf, die im Randbereich der Anzeigeeinheit angeordnet und zur Bilderfassung oder zur 3D-Erfassung des Beobachtungsraums vorgesehen ist.

Alternativ dazu kann die Näherungssensorik als Empfänger einen Bildsensor mit oder ohne Optik aufweisen, die/der im Randbereich der Anzeigeeinheit angeordnet und zur Bilderfassung oder zur 3D-Erfassung des Beobachtungsraums vorgesehen ist.

Schließlich ist es auch möglich, dass die Näherungssensorik einen Sender aufweist, der bei für die 2D- oder 3D-Erfassung des Beobachtungsraums ungenügendem Umgebungslicht aktivierbar ist.

Die Erfindung wird nachfolgend anhand mehrerer Ausführungsbeispiele und unter Bezug auf die Zeichnung näher erläutert. Im Einzelnen zeigen dabei:
- Fig. 1: eine schematische Darstellung der für die Detektion von nicht sichtbarem Licht durch Anordnung entsprechender Sensorik im Randbereich eines Displays wesentlichen Merkmale einer in diesem Ausführungsbeispiel als LCD-Anzeigevorrichtung ausgebildeten Anzeigenvorrichtung gemäß einem ersten Ausführungsbeispiel,
- Fig. 2: eine schematische Darstellung der für die Detektion von nicht sichtbarem Licht durch Anordnung entsprechender Sensorik im Randbereich eines Displays wesentlichen Merkmale einer LCD-Anzeigevorrichtung gemäß einem zweiten Ausführungsbeispiel,
- Fig. 3: eine schematische Darstellung der für die Detektion von nicht sichtbarem Licht durch Anordnung entsprechender Sensorik im Randbereich eines Displays wesentlichen Merkmale einer LCD-Anzeigevorrichtung gemäß einem dritten Ausführungsbeispiel, und
- Fig. 4: eine schematische Darstellung der für die Detektion von nicht sichtbarem Licht durch Anordnung entsprechender Sensorik im Randbereich eines Displays wesentlichen Merkmale einer LCD-Anzeigevorrichtung gemäß einem vierten Ausführungsbeispiel.

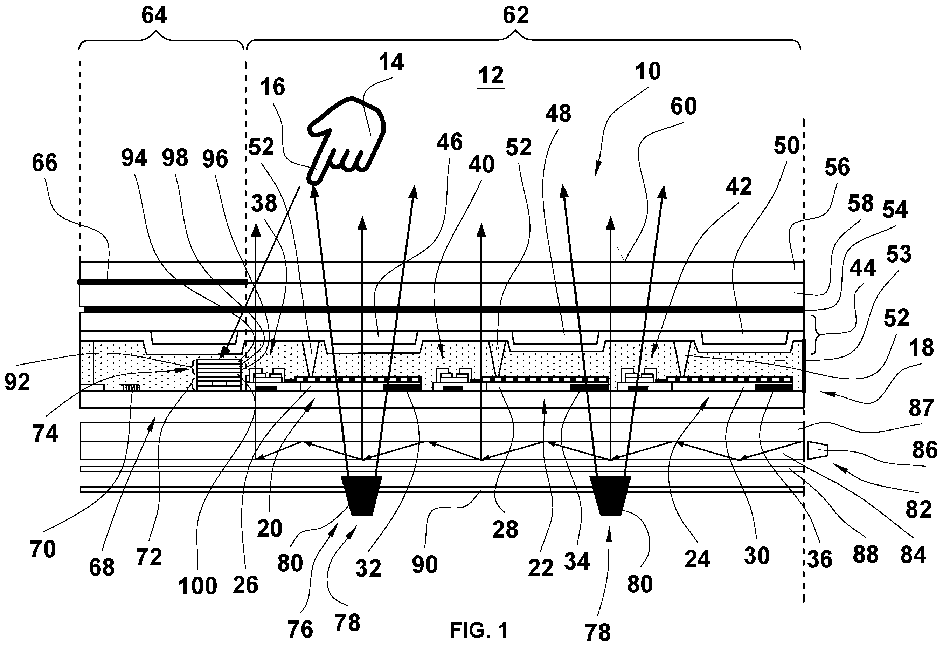

Fig. 1 zeigt schematisch die für die Erfindung wesentlichen Bestandteile einer Anzeigevorrichtung 10 mit im Randbereich angeordneten Teilen einer Näherungssensorik zur Erkennung eines sich innerhalb eines Beobachtungsraums 12 vor der Anzeigevorrichtung 10 befindenden Objekts, wie z.B. eine Hand 14 oder ein Finger 16 der Hand 14 einer Person, wie es insbesondere zur Gestenerkennung und/oder Fernfeldabtastung zweckmäßig ist.

Die Anzeigevorrichtung 10 weist eine Anzeigeeinheit 11 mit einem LCD-Panel 18 auf, auf dem R-, G- und B-Pixel 20,22,24 angeordnet sind, die jeweils beispielsweise eine ITO-Elektrode 26,28,30 und eine Pixel-Kapazität 32,34,36 aufweisen. Das LCD-Panel 18 ist als TFT-Glas ausgeführt und weist in Planar-Technologie hergestellte, den einzelnen Pixeln zugeordnete TFT-Transistoren 38,40,42 auf.

Oberhalb des LCD-Panel 18 befindet sich eine Farbfilterschicht 44 mit einem R-Filter 46 oberhalb des R-Pixels 20, einem G-Filter 48 oberhalb des G-Pixel 22 und mit einem B-Filter 50 oberhalb des bzw. jedes B-Pixel 24.

Die Farbfilterschicht 44 ist durch Abstandshalter 52 in gleichmäßigem Abstand zum LCD-Panel 18 gehalten. Der Zwischenraum zwischen beiden ist von Flüssigkristallmaterial 53 und zum umlaufenden Rand hin verschlossen, wie es bei LCD-Displays grundsätzlich bekannt ist.

Oberhalb der Farbfilterschicht 44 befindet sich ein Touch-Panel 54, das der Erkennung einer Berührung der Anzeigevorrichtung 10 dient. Derartige TouchPanel 54 o.dgl. Berührungssensoriken für Anzeigevorrichtungen sind grundsätzlich bekannt, weshalb an dieser Stelle auf deren Konstruktion nicht weiter eingegangen werden soll.

Oberhalb des Touch-Panel 54 befindet sich eine Abdeckscheibe 56 (auch coverlens genannt), die mittels Optical Bonding 58 mit dem Touch-Panel 54 verbunden ist.

Die Vorderseite 60 der Anzeigevorrichtung 10 weist die durch die Pixel definierte Anzeigefläche 62 auf, um die herum ein nicht für Anzeigezwecke zu nutzender Randbereich 64 verläuft. Dieser Randbereich 64 ist durch eine für IR-Licht durchlässige Bedruckung 66 an der Unterseite der Abdeckscheibe 56 abgedunkelt. Innerhalb dieses Randbereichs 64 erstreckt sich ein Überstandsbereich 68 des LCD-Panel 18, in dem beispielsweise das Routing 70 sowie elektronische Schaltkreise und/oder elektronische Bauteile 72 für die Ansteuerung der Pixel angeordnet ist.

Erfindungsgemäß wird nun dieser Überstandsbereich 68 des LCD-Panel 18 ausgenutzt, um dort zumindest Teile der Näherungssensorik anzuordnen. Im Ausführungsbeispiel gemäß Fig. 1 befinden sich in diesem Überstandsbereich 68 beispielsweise Empfänger 74 der Näherungssensorik 76, zu der ferner Sender 78 gehören, die in diesem Ausführungsbeispiel IR-Strahlung abgeben. Die Sender 78 sind in diesem Ausführungsbeispiel als IR-Sendedioden 80 ausgebildet, die unterhalb der Anzeigevorrichtung 10 angeordnet sind. Unterhalb der Anzeigevorrichtung 10 ist zunächst eine Hinterleuchtungseinheit 82 angeordnet, die eine Lichtleiterschicht 84 aufweist, in der seitlich durch Hinterleuchtungslichtquellen 86 eingespeistes Licht in Richtung Anzeigefläche 62 der Anzeigevorrichtung 10 gerichtet wird. Auf der Lichtleiterschicht 84 befindet sich eine Diffusorschicht 87 zur Vergleichmäßigung des in Richtung Anzeigefläche 62 gerichteten Hinterleuchtungslichts. Bei den Hinterleuchtungslichtquellen 86 handelt es sich ebenfalls zweckmäßigerweise um LEDs. Zur Hinterleuchtungseinheit 82 gehört auch ein Reflektor 88, der nach unten aus der Lichtleiterschicht 84 austretendes Hinterleuchtungslicht reflektiert. Bei diesem Reflektor 88 handelt es sich um einen für IR-Strahlung durchlässigen Reflektor, weshalb die Sender 78, von einer Haltestruktur 90 gehalten unterhalb der Hinterleuchtungseinheit 82 angeordnet sein können.

Wie in Fig. 1 anhand des sich im Beobachtungsraum 12 befindenden Fingers 16 und der Hand 14 eines Benutzers angedeutet, wird IR-Strahlung der Sender 78 in Richtung auf den/die Empfänger 74 reflektiert, womit die Ortung und Detektion der Hand möglich ist.

Wie die Sender 78 sind zweckmäßigerweise auch die Empfänger 74 der Näherungssensorik 76 als Dioden ausgebildet, und zwar in diesem Ausführungsbeispiel als PIN-Fotodioden 92 für den Empfang von IR-Strahlung. Eine derartige PIN-Fotodiode 92 weist beispielsweise eine p-dotierte Halbleitermaterialschicht 94, eine n-dotierte Halbleitermaterialschicht 96 und eine Intrinsik-, d.h. eigenleitende Halbleitermaterialschicht 98 zwischen den beiden zuvor beschriebenen Halbleitermaterialschichten auf. Aus Platzsparungsgründen sind die PIN-Fotodioden 92 auf einem elektronischen Bauteil 72 angeordnet, und zwar unter Zwischenschaltung einer Isolationsschicht 100.

Sämtliche elektronischen und optoelektronischen Bauteile des LCD-Panel 18 sind in Planar-Technologie aufgebracht, also schichtweise aufgebracht. Dies gilt insbesondere auch für die erfindungsgemäß vorgesehenen PIN-Fotodioden 92, die im Ausführungsbeispiel gemäß Fig. 1 als vertikale PIN-Dioden konzipiert sind.

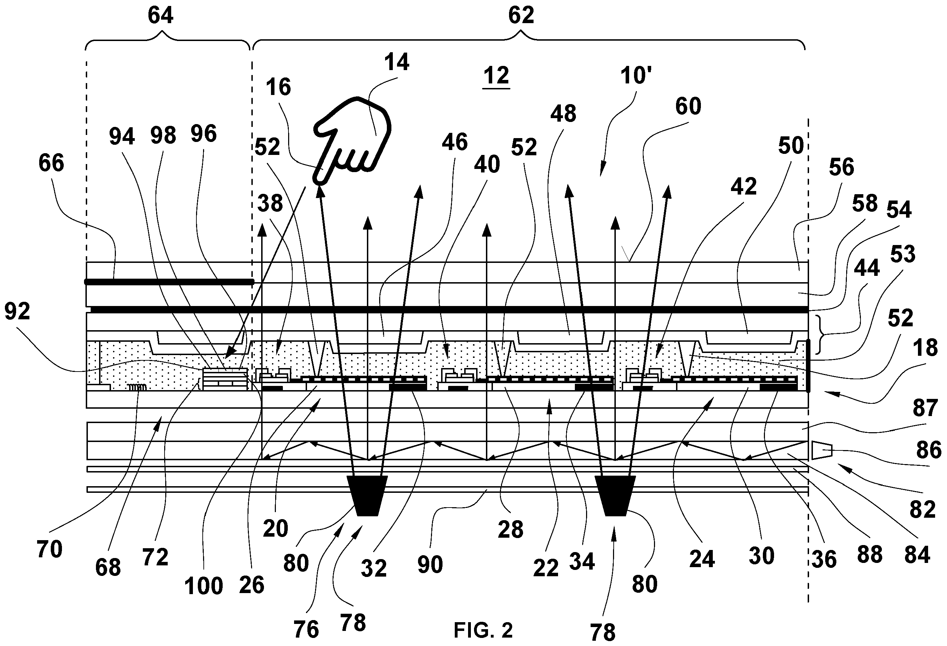

Im Ausführungsbeispiel gemäß Fig. 2 ist die Anzeigevorrichtung 10' mit Horizontal-PIN-Fotodioden 92 versehen, bei denen die drei Halbleitermaterialschichten nicht übereinander, sondern nebeneinander angeordnet sind, und zwar wiederum auf einer Isolationsschicht 100, die ihrerseits auf dem elektronischen Bauteil 72 angeordnet ist. Im Übrigen gilt für die Bezugszeichen der Fig. 2, dass dort all diejenigen Elemente, die konstruktions- bzw. funktionsgleich mit den Elementen der Fig. 1 sind, mit den gleichen Bezugszeichen wie in Fig. 1 gekennzeichnet sind.

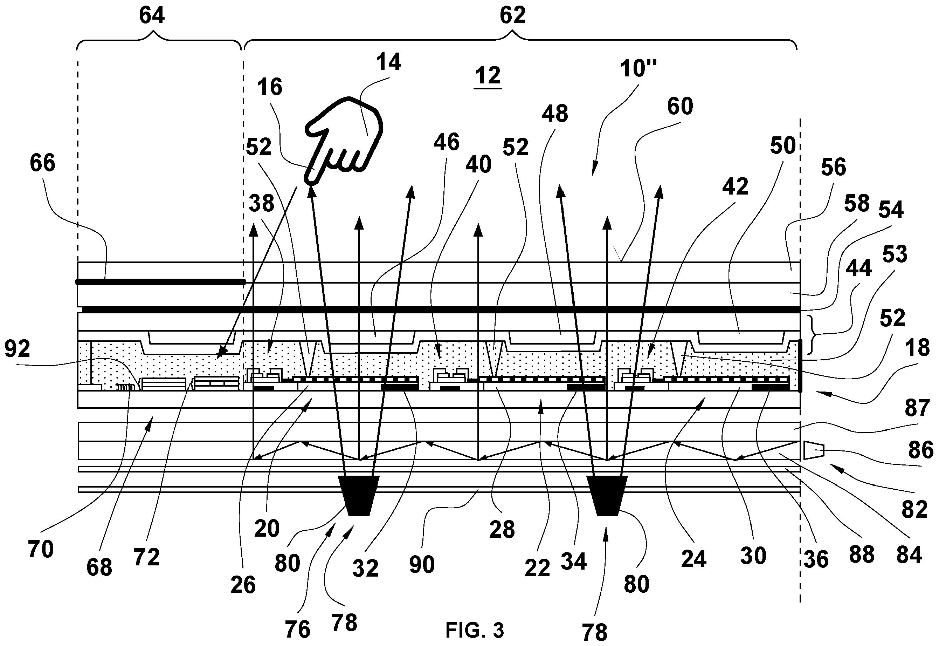

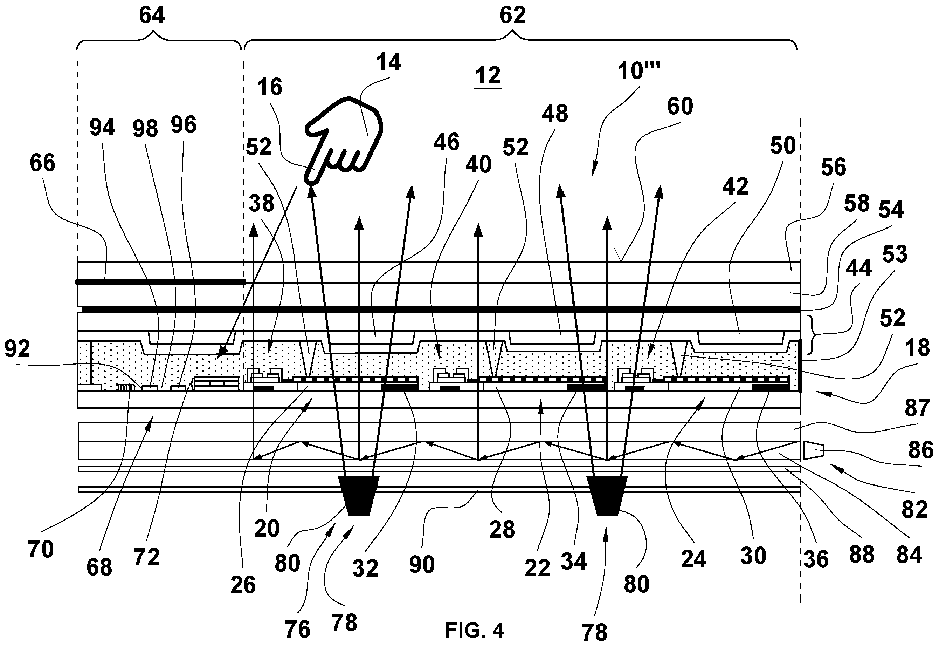

In den Fign. 3 und 4 sind zwei weitere Varianten einer Anzeigevorrichtung 10" und 10‴ gezeigt, wie sie erfindungsgemäß vorgeschlagen werden. Auch für die Fign. 3 und 4 gilt, dass dort diejenigen konstruktions- bzw. baugleichen und/oder funktionsmäßig gleichen Elemente mit den gleichen Bezugszeichen wie in Fig. 1 gekennzeichnet sind.

In Fig. 3 ist zu erkennen, dass die PIN-Fotodioden 92 als Vertikal-PIN-Fotodioden ausgebildet sind und neben dem elektronischen Bauteil 72 im Überstandsbereich 68 des LCD-Panel 18 angeordnet sind. In Fig. 4 sind die PIN-Fotodioden 92 als Horizontal-PIN-Fotodioden ausgebildet.

### BEZUGSZEICHENLISTE

- 10: Anzeigevorrichtung
- 10': Anzeigevorrichtung
- 10": Anzeigevorrichtung
- 10‴: Anzeigevorrichtung
- 11: Anzeigeeinheit
- 12: Beobachtungsraum
- 14: Hand
- 16: Finger
- 18: LCD-Panel
- 20: R-Pixel
- 22: G-Pixel
- 24: B-Pixel
- 26: ITO-Elektrode
- 28: ITO-Elektrode
- 30: ITO-Elektrode
- 32: Pixel-Kapazität
- 34: Pixel-Kapazität
- 36: Pixel-Kapazität
- 38: TFT-Transistoren
- 40: TFT-Transistoren
- 42: TFT-Transistoren
- 44: Farbfilterschicht
- 46: R-Filter
- 48: G-Filter
- 50: B-Filter
- 52: Abstandshalter
- 53: Flüssigkristallmaterial
- 54: Touch-Panel
- 56: Abdeckscheibe
- 58: optical Bonding
- 60: Vorderseite
- 62: Anzeigefläche
- 64: Randbereich
- 66: Bedruckung
- 68: Überstandsbereich
- 70: Routing
- 72: elektronisches Bauteil
- 74: Empfänger
- 76: Näherungssensorik
- 78: Sender
- 80: IR-Sendedioden
- 82: Hinterleuchtungseinheit
- 84: Lichtleiterschicht
- 86: Hinterleuchtungslichtquellen
- 87: Diffusorschicht
- 88: Reflektor
- 90: Haltestruktur
- 92: PIN-Fotodioden
- 94: p-dotierte Halbleitermaterialschicht
- 96: n-dotierte Halbleitermaterialschicht
- 98: eigenleitende Halbleitermaterialschicht
- 100: Isolationsschicht

### ABKÜRZUNGEN

- IR:: Infrared
- AA:: Active area
- WA:: Viewing area
- TP:: Touch panel
- PD:: Photodiode
- LCD:: Liquid crystal display
- TFT:: Thin film transistor
- LTPS:: Low temperature polysilicon
- a-Si:: amorphous silicon
- PIN PD:: PIN type semiconductor photodiode
- FPC:: Flex printed circuit
- COG:: Chip on glass
- OCR:: Optically clear resin
- OCA:: Optically clear adhesive
- BL:: Backlight
- BLU:: Backlight unit
- CG:: Cover glass
- GG:: Glass-Glass
- AR:: Antireflection
- AG:: Antiglare
- AFP:: Antifinger print
- CID:: Center information display
- CF:: Color filter glass

### LITERATURLISTE

US 2009/0231497 A1
US 2010/0220269 A1
US 2011/0221705 A1
US 2011/0115749 A1
US 2011/0193818 A1
WO 2014/156399 A1
US 2014/0192023 A1
US 2015/0084928 A1
US 2015/0084928 A1
US 2018/0069609 A1
WO 2019/012046 A1
PCT/EP2019/059234
DE 10 2016 100 363 A1
GB 2 486 000 A
KRATZ, Sven; ROHS, Michael: Hoverflow: Exploring Around-Device Interaction with IR Distance Sensors, 11th International Conference on Human-Computer Interaction with Mobile Devices and Services, MobileHCI '09, Bonn, Germany, September 15-18, 2009, Conference Proceedings, ISBN 978-1-60558-281-8. New York: ACM, 2009. Article No. 42,
KRATZ, Sven: Sensor-Based User Interface Concepts for Continuous, Around-Device and Gestural Interaction on Mobile Devices. Dissertation, Fakultät für Mathematik, Informatik und Statistik, Ludwig-Maximilians-Universität München. München: LMU, 2012,
OH, KyongSae; HWANG, Seok-Hee; YOU, SeungBin et al.: Gesture Sensor for Mobile Devices - White Paper, Firmenanschrift, Samsung Electronics Co. Ltd. Suwon-si, Gyeonggi-do, KR: Samsung, 2013,
BÜRGI, L. [u. a.]: Optical proximity and touch sensors based on monolithically integrated polymer photodiodes and polymer LEDs. In: Organic Electronics, Vol. 7, Nr. 2, 2006, S. 114-120. DOI: https://doi.org/10.1016/j.or-gel.2005.12.002. Science Direct [online],
ZHOU, X. [u. a.]: Highly Sensitive a-Si:H PIN Photodiode Gated LTPS TFT for Optical In-Display Fingerprint Identification. In: Society for Information Display International Symposium Digest of Technical Papers, Vol. 49, Nr. 1, 2018, S. 490-493. DOI: https://doi.org/10.1002/sdtp.12608. Wiley Online Library [online].

## Patentansprüche

1. Anzeigevorrichtung mit integrierter, optisch arbeitender Näherungssensorik zur Erkennung eines sich innerhalb eines Beobachtungsraums vor der Anzeigevorrichtung befindenden Objekts wie z.B. einer Hand oder eines Fingers einer Hand einer Person insbesondere zur Gestenerkennung und/oder Fernfeldabtastung, mit
- einer Anzeigeeinheit (11), die eine Vorderseite (60) mit einer Information anzeigenden Anzeigefläche (62), einen an die Anzeigefläche (62) angrenzenden, für die Anzeige von Information nicht verwendeten Randbereich (64) und eine Rückseite aufweist, und
- einer Näherungssensorik (76) mit mindestens einem Sender (78) zum Aussenden von Sensorstrahlung in den Beobachtungsraum hinein und mit mehreren Empfängern (74) zum Empfangen von aus dem Beobachtungsraum reflektierter Sensorstrahlung,
- wobei der mindestens eine Sender (78) der Näherungssensorik (76) unterhalb der Anzeigeeinheit (11), z.B. unterhalb der von der Anzeigefläche (62) eingenommenen Region oder unterhalb des Randbereichs (64) der Anzeigeeinheit (11) oder an der Rückseite der Anzeigeeinheit (11) oder der Rückseite der Anzeigeeinheit (11) zugewandt oder in der Anzeigeeinheit (11) angeordnet ist und die Empfänger (74) der Näherungssensorik (76) in dem an die Anzeigefläche (62) angrenzenden Randbereich (64) auf der Vorderseite (60) oder der Rückseite der Anzeigeeinheit (11) angeordnet sind,
- wobei die Anzeigeeinheit (11) ein TFT-Anzeigepanel (18) mit einer die Vorderseite (60) der Anzeigeeinheit (11) bildenden Oberseite, die einen die Anzeigefläche (62) bildenden Bereich mit TFT-Transistoren (38,40,42) und einen diesen Bereich umgebenden, den Randbereich (64) bildenden Überstandsbereich (68) aufweist, und mit einer der Oberseite abgewandten Unterseite und eine oberhalb der oder auf der Oberseite des Anzeigepanels (18) angeordnete Farbfilterschicht (44) aufweist,
- wobei die Empfänger (74) der Näherungssensorik (76) innerhalb des Überstandsbereichs (68) des Anzeigepanels (18) auf dessen Ober- und/oder Unterseite angeordnet sind und
- wobei die Empfänger (74) der Näherungssensorik (76) jeweils als Halbleiterdiode ausgebildet sind, die in Dünnfilm-Technologie auf dem Anzeigepanel (18) ausgebildete Halbleiterschichten (94,96,98) aufweist, die nebeneinander oder übereinander und ferner aneinander angrenzend angeordnet sind.

2. Anzeigevorrichtung nach Anspruch 1, **dadurch gekennzeichnet, dass** der mindestens eine Sender (78) der Näherungssensorik (76) als Halbleiterdiode ausgebildet ist, die in Dünnfilm-Technologie auf dem Anzeigepanel (18) ausgebildete Halbleiterschichten aufweist.

3. Anzeigevorrichtung nach Anspruch 1 und 2, **dadurch gekennzeichnet, dass** die jeweilige Halbleiterdiode (94,96,98) als IR-Halbleiterdiode zum Empfangen oder zum Senden von IR-Strahlung ausgebildet ist und dass der Randbereich (64) durch eine für IR-Strahlung durchlässige Bedruckung (66) an der Unterseite der Abdeckscheibe (56) abgedunkelt ist.

4. Anzeigevorrichtung nach einem der Ansprüche 1 bis 3, **dadurch gekennzeichnet, dass** die Halbleiterdiode (94,96,98) jedes Empfänger (74) der Näherungssensorik (76) als PIN-Fotodiode (92) ausgebildet ist und eine Intrinsik-Halbleiterschicht (98) zwischen zwei entgegengesetzt dotierten Halbleiterschichten (94,96) aufweist.

5. Anzeigevorrichtung nach einem der Ansprüche 1 bis 4, **dadurch gekennzeichnet, dass** das TFT-Anzeigepanel (18) innerhalb des Überstands des Anzeigepanels (18) in Dünnfilm-Technologie ausgebildete elektronische Bauteile (72) auf dessen Ober- und/oder Unterseite aufweist.

6. Anzeigevorrichtung nach einem der Ansprüche 1 bis 5, **dadurch gekennzeichnet, dass** die Halbleiterdiode (94,96,98) jedes Empfängers (74) und/oder die Halbleiterdiode (94,96,98) des mindestens einen Senders (78) der Näherungssensorik (76), auf einer in Dünnfilm-Technologie hergestellten Isolationsschicht (100) ausgebildet ist, die auf einem in Dünnfilm-Technologie hergestellten, im Überstandsbereich (68) des TFT-Anzeigepanels (18) angeordneten elektronischen Bauteil (72) oder auf einem Teil davon ausgebildet ist.

7. Anzeigevorrichtung nach einem der Ansprüche 1 bis 6, **dadurch gekennzeichnet, dass** die von dem mindestens einen Sender (78) abgegebene und von den Empfängern (74) oder Näherungssensorik (76) empfangene Strahlung IR-Strahlung ist.

8. Anzeigevorrichtung nach einem der Ansprüche 1 bis 7, **dadurch gekennzeichnet, dass** die Anzeigeeinheit (11) als LCD-Matrix-Anzeigeeinheit ausgebildet ist und in einem allseitig abgedichteten Zwischenraum zwischen der Oberseite des Anzeigepanels (18) und einer Abdeckscheibe ein Flüssigkristallmedium aufweist.

9. Anzeigevorrichtung nach einem der Ansprüche 1 bis 8, **dadurch gekennzeichnet, dass** der mindestens eine Sender (78) und/oder jeder Empfänger (74) der Näherungssensorik (76) mit einer Optik zur Ausrichtung der Strahlung in Richtung auf den Beobachtungsraum vor der Anzeigefläche (62) versehen ist.

10. Anzeigevorrichtung nach einem der Ansprüche 1 bis 9, **gekennzeichnet durch** eine nicht-optisch arbeitende Berührungssensorik, wie z.B. eine kapazitiv, resistiv, induktiv oder auf Ultraschallbasis arbeitende Berührungssensorik.

11. Anzeigevorrichtung nach Anspruch 10, **dadurch gekennzeichnet, dass** die Berührungssensorik ein Touch-Panel (54) aufweist, das auf der Vorderseite (60) der Anzeigeeinheit (11) oder auf der Farbfilterschicht (44) oder hinter einer vor der Anzeigeeinheit (11) oder vor der Farbfilterschicht (44) angeordneten Abdeckscheibe (56) positioniert ist.

12. Anzeigevorrichtung nach einem der Ansprüche 1 bis 11, **dadurch gekennzeichnet, dass** bei Anordnung sowohl des mindestens einen Senders (78) als auch der Empfänger (74) der Näherungssensorik (76) im Randbereich (64) der Anzeigeeinheit (11) der mindestens eine Sender (78) und die Empfänger (74) zur Vermeidung eines Übersprechens beide gegeneinander abgeschottet sind.

13. Anzeigevorrichtung nach einem der Ansprüche 1 bis 12, **dadurch gekennzeichnet, dass** die Näherungssensorik (76) als Empfänger eine Empfänger-Matrix mit oder ohne Optik aufweist, die im Randbereich (64) der Anzeigeeinheit (11) angeordnet und zur Bilderfassung oder zur 3D-Erfassung des Beobachtungsraums vorgesehen ist.

14. Anzeigevorrichtung nach Anspruch 13, **dadurch gekennzeichnet, dass** die Näherungssensorik (76) als Empfänger einen Bildsensor mit oder ohne Optik aufweist, der im Randbereich (64) der Anzeigeeinheit (11) angeordnet und zur Bilderfassung oder zur 3D-Erfassung des Beobachtungsraums vorgesehen ist.

15. Anzeigevorrichtung nach einem der Ansprüche 1 bis 14, **dadurch gekennzeichnet, dass** die Näherungssensorik (76) einen Sender (78) aufweist, der bei für die 2D- oder 3D-Erfassung des Beobachtungsraums ungenügendem Umgebungslicht aktivierbar ist.

16. Anzeigevorrichtung nach einem der Ansprüche 1 bis 15, **dadurch gekennzeichnet, dass** das TFT-Anzeigepanel (18) an zumindest einem Randabschnitt (64) über die Farbfilterschicht (44) übersteht und dieser Überstand den seitlich an die Anzeigefläche (62) angrenzenden Randbereich (64) bildet oder dass das TFT-Panel-Anzeigepanel (18) unter anderem Pixel (20,22,24) und in Dünnfilm-Technologie hergestellte Transistoren (38,40,42) aufweist, die zusammen die Anzeigefläche (62) der Anzeigeeinheit (11) repräsentieren, und das TFT-Anzeigepanel (18) an zumindest einem Randabschnitt (64) über die Anzeigefläche (62) übersteht und dieser Überstand den seitlich an die Anzeigefläche (62) angrenzenden Randbereich (64) bildet.

## Claims

1. A display device comprising an integrated, optically operating proximity sensor system for detecting an object, such as e.g. a hand or a finger of a person's hand, present within an observation space in front of the display device, in particular for gesture recognition and/or far-field sensing, the display device being provided with
- a display unit (11) having a front side (60) with a display surface (62) displaying information, an edge region (64) adjacent to the display surface (62) and not used for the display of information, and a rear side, and
- a proximity sensor system (76) comprising at least one transmitter (78) for emitting sensor radiation into the observation space, and comprising at least one receiver (74) for receiving sensor radiation effected from the observation space,
- wherein the at least one transmitter (78) of the proximity sensor system (76) is arranged below the display unit (11), e.g. below the region occupied by the display surface (62), or below the edge region (64) of the display unit (11) or on the rear side of the display unit (11) or facing the rear side of the display unit (11) or in the display unit (11), and the at least one receiver (74) of the proximity sensor system (76) is arranged in the edge region (64) adjacent to the display surface (62) on the front (60) or the rear side of the display unit (11),
- wherein the display unit (11) comprises a TFT display panel (18) having an upper side forming the front side (60) of the display unit (11) which comprises an area aligned with the display surface and having TFT transistors forming the display surface (62), and a protrusion region (68) surrounding this area and forming the edge region (64), and having a lower side facing away from the upper side, and comprises a color filter layer (44) arranged above or on the upper side of the display panel (18),
- wherein the receivers (74) of the proximity sensor system (76) is arranged within the protrusion region (68) of the display panel (18) on the upper or the lower side thereof, and
- wherein the receivers (74) of the proximity sensor system (76) are each configured as a semiconductor diode comprising semiconductor layers (94, 96, 98) formed in TFT technology on the display panel (18) and arranged side-by-side or above each other and, further, adjacent to each other.

2. The display device according to claim 1, **characterized in that** the at least one transmitter (78) of the proximity sensor system (76) is configured as a semiconductor diode comprising semiconductor layers formed in TFT technology on the display panel (18).

3. The display device according to claims 1 and 2, **characterized in that** the respective semiconductor diode (94, 96, 98) is formed as an IR semiconductor diode for receiving or transmitting IR radiation, and the edge portion (64) is darkened by a print (66) on the lower side of the cover glass (56), which print is transparent to IR light.

4. The display device according to one of claims 1 to 3, **characterized in that** the semiconductor diode (94, 96, 98) of each receiver (74) of the proximity sensor system (76) is designed as a PIN photodiode (92) and comprises an intrinsic semiconductor layer (98) between two oppositely doped semiconductor layers (94, 96).

5. The display device according to one of claims 1 to 4, **characterized in that**, within the protrusion of the display panel (18), the TFT display panel (18) comprises electronic components (72) formed in thin-film technology on the upper and/or lower side thereof.

6. The display device according to one of claims 1 to 5, **characterized in that** the semiconductor diode (94, 96, 98) of each receiver (74) and/or the semiconductor diode (94, 96, 98) of the at least one transmitter (78) of the proximity sensor system (78) is formed on an insulation layer (100) made in thin-film technology which is arranged on an electronic component (72), or a part thereof, made in thin-film technology and arranged in the protrusion region (68) of the TFT display panel (18).

7. The display device according to one of claims 1 to 6, **characterized in that** the radiation emitted by the at least one transmitter (78) and received by the at least one receiver (74) or proximity sensor system (76) is IR radiation.

8. The display device according to one of claims 1 to 7, **characterized in that** the display unit (11) is designed as a LCD matrix display unit and comprises a liquid crystal medium in a gap between the upper side of the display panel (18) and a cover glass, said gap being sealed all around.

9. The display device according to one of claims 1 to 8, **characterized in that** the at least one transmitter (78) and/or each receiver (74) of the proximity sensor system (76) is provided with optics for directing the radiation toward the observation space in front of the display surface (62).

10. The display device according to one of claims 1 to 9, **characterized by** a non-optically operating touch sensor system such as e.g. a touch sensor system operating capacitively, resistively, inductively or on an ultrasound basis.

11. The display device according to claim 10, **characterized in that** the touch sensor system comprises a touch panel (54) which is positioned on the front side (60) of the display unit (11) or on the color filter layer (44) or behind a cover glass (54) arranged in front of the display unit (11) or in front of the color filter layer (44).

12. The display device according to one of claims 1 to 11, **characterized in that** when both the at least one transmitter (78) and the receivers (84) of the proximity sensor system (76) are arranged in the edge region (64) of the display unit (11), the at least one transmitter (78) and the receivers (74) are isolated from each other to prevent crosstalk.

13. The display device according to one of claims 1 to 12, **characterized in that** the proximity sensor system (76) comprises as the receiver a receiver matrix with or without optics which is arranged in the edge region (64) of the display unit (11) and is provided for image acquisition or 3D acquisition of the observation space.

14. The display device according to claim 13, **characterized in that** the proximity sensor system (76) comprises as the receiver an image sensor with or without optics, which is arranged in the edge region (64) of the display unit (11) and is provided for image acquisition or 3D acquisition of the observation space.

15. The display device according to one of claims 1 to 14, **characterized in that** the proximity sensor system (76) comprises a transmitter (78) that can be activated if the ambient light is insufficient for 2D- or 3D acquisition of the observation space.

16. The display device according to one of claims 1 to 15, **characterized in that** the TFT display panel (18) protrudes beyond the color filter layer (44) at at least one edge section (64) and this protrusion forms the edge region (64) laterally adjacent to the display surface (62), or that the TFT panel display panel (18) comprises, among others, pixels (20, 22, 24) and transistors (38, 40, 42) made in thin-film technology, which together represent the display surface (62) of the display unit (11), and the TFT display panel (18) protrudes beyond the display surface (62) at at least one edge section (64) and this this protrusion forms the edge region (64) laterally adjacent to the display surface (62).

## Revendications

1. Dispositif d'affichage avec un système de capteurs de proximité intégré, à fonctionnement optique, destiné à la détection d'un objet situé à l'intérieur d'un espace d'observation devant le dispositif d'affichage, comme par ex. une main ou un doigt d'une main d'une personne, en particulier pour la détection de gestes et/ou le balayage de champ lointain, avec
- une unité d'affichage (11) qui présente une face avant (60) avec une surface d'affichage (62) affichant des informations, une zone de bord (64), contiguë à la surface d'affichage (62), non utilisée pour l'affichage d'informations, et une face arrière, et
- un système de capteurs de proximité (76) avec au moins un émetteur (78) destiné à l'émission d'un rayonnement de capteur vers l'intérieur de l'espace d'observation, et avec plusieurs récepteurs (74) destinés à la réception du rayonnement de capteur réfléchi à partir de l'espace d'observation,
- l'au moins un émetteur (78) du système de capteurs de proximité (76) étant disposé au-dessous de l'unité d'affichage (11), par ex. au-dessous de la région occupée par la surface d'affichage (62) ou au-dessous de la zone de bord (64) de l'unité d'affichage (11) ou sur la face arrière de l'unité d'affichage (11) ou tournée vers la face arrière de l'unité d'affichage (11) ou dans l'unité d'affichage (11), et les récepteurs (74) du système de capteurs de proximité (76) étant disposés dans la zone de bord (64) contiguë à la surface d'affichage (62) sur la face avant (60) ou la face arrière de l'unité d'affichage (11),
- l'unité d'affichage (11) présentant un panneau d'affichage TFT (18), avec une face supérieure, formant la face avant (60) de l'unité d'affichage (11), qui présente une zone formant la surface d'affichage (62) avec des transistors TFT (38, 40, 42) et une zone en saillie (68) entourant cette zone, formant la zone de bord (64), et avec une face inférieure éloignée de la face supérieure et une couche de filtre couleur (44) disposée au-dessus de ou sur la face supérieure du panneau d'affichage (18),
- les récepteurs (74) du système de capteurs de proximité (76) étant disposés à l'intérieur de la zone en saillie (68) du panneau d'affichage (18) sur sa face supérieure et/ou sa face inférieure, et
- les récepteurs (74) du système de capteurs de proximité (76) étant constitués respectivement en tant que diode à semi-conducteur qui présente des couches semi-conductrices (94, 96, 98) constituées selon la technologie de couche mince sur le panneau d'affichage (18) et qui sont disposées de façon juxtaposée ou superposée et qui sont en outre contiguës entre elles.

2. Dispositif d'affichage selon la revendication 1, **caractérisé en ce que** l'au moins un émetteur (78) du système de capteurs de proximité (76) est constitué en tant que diode à semi-conducteur qui présente des couches semi-conductrices constituées selon la technologie de couche mince sur le panneau d'affichage (18).

3. Dispositif d'affichage selon la revendication 1 et 2, **caractérisé en ce que** la couche semi-conductrice (94, 96, 98) respective est constituée en tant que diode à semi-conducteur IR pour la réception ou pour l'émission de rayonnement IR, et **en ce que** la zone de bord (64) est assombrie par une impression (66), transparente au rayonnement IR, sur la face inférieure du disque de recouvrement (56).

4. Dispositif d'affichage selon l'une des revendications 1 à 3, **caractérisé en ce que** la couche semi-conductrice (94, 96, 98) de chaque récepteur (74) du système de capteurs de proximité (76) est constituée en tant que photodiode PIN (92) et présente une couche semi-conductrice intrinsèque (98) entre deux couches semi-conductrices (94, 96) dopées de manière opposée.

5. Dispositif d'affichage selon l'une des revendications 1 à 4, **caractérisé en ce que**, sur sa face supérieure et/ou face inférieure, le panneau d'affichage TFT (18) présente, à l'intérieur de la saillie du panneau d'affichage (18), des composants (72) électroniques constitués selon la technologie de couche mince.

6. Dispositif d'affichage selon l'une des revendications 1 à 5, **caractérisé en ce que** la diode à semi-conducteur (94, 96, 98) de chaque récepteur (74) et/ou la diode à semi-conducteur (94, 96, 98) de l'au moins un émetteur (78) du système de capteurs de proximité (76) est constituée sur une couche d'isolation (100), réalisée selon la technologie de couche mince, qui est constituée sur un composant (72) électronique, ou sur une partie de celui-ci, disposé dans la zone en saillie (68) du panneau d'affichage TFT (18), composant qui est réalisé selon la technologie de couche mince.

7. Dispositif d'affichage selon l'une des revendications 1 à 6, **caractérisé en ce que** le rayonnement délivré par l'au moins un émetteur (78) et reçu par les récepteurs (74) ou le système de capteurs de proximité (76) est un rayonnement IR.

8. Dispositif d'affichage selon l'une des revendications 1 à 7, **caractérisé en ce que** l'unité d'affichage (11) est constituée en tant qu'unité d'affichage à matrice LCD et présente un milieu de cristaux liquides dans un espace intermédiaire, rendu étanche de toutes parts, entre la face supérieure du panneau d'affichage (18) et un disque de recouvrement.

9. Dispositif d'affichage selon l'une des revendications 1 à 8, **caractérisé en ce que** l'au moins un émetteur (78) et/ou chaque récepteur (74) du système de capteurs de proximité (76) est muni d'une optique destinée à orienter le rayonnement en direction de l'espace d'observation devant la surface d'affichage (62).

10. Dispositif d'affichage selon l'une des revendications 1 à 9, **caractérisé par** un système de capteurs de contact ne fonctionnant pas de façon optique, par ex. un système de capteurs de contact fonctionnant de façon capacitive, résistive, inductive ou à base d'ultrasons.

11. Dispositif d'affichage selon la revendication 10, **caractérisé en ce que** le système de capteurs de de contact présente un panneau tactile (54) qui est positionné sur la face avant (60) de l*'*unité d'affichage (11) ou sur la couche de filtre couleur (44) ou derrière un disque de recouvrement (56) disposé devant l'unité d'affichage (11) ou devant la couche de filtre couleur (44).

12. Dispositif d'affichage selon l'une des revendications 1 à 11, **caractérisé en ce que**, lors de la disposition aussi bien de l'au moins un émetteur (78) que des récepteurs (74) du système de capteurs de proximité (76) dans la zone de bord (64) de l'unité d'affichage (11), l'au moins un émetteur (78) et les récepteurs (74) sont tous deux isolés mutuellement afin d'éviter une diaphonie.

13. Dispositif d'affichage selon l'une des revendications 1 à 12, **caractérisé en ce que** le système de capteurs de proximité (76) présente en tant que récepteurs une matrice de récepteurs, avec ou sans optique, qui est disposée dans la zone de bord (64) de l'unité d'affichage (11) et qui est prévue pour la capture d'images ou pour la capture 3D de l'espace d'observation.

14. Dispositif d'affichage selon la revendication 13, **caractérisé en ce que** le système de capteurs de proximité (76) présente en tant que récepteurs un capteur d'images, avec ou sans optique, qui est disposé dans la zone de bord (64) de l'unité d'affichage (11) et qui est prévu pour la capture d'images ou pour la capture 3D de l'espace d'observation.

15. Dispositif d'affichage selon l'une des revendications 1 à 14, **caractérisé en ce que** le système de capteurs de proximité (76) présente un émetteur (78) qui peut être activé en présence d'une lumière ambiante insuffisante pour la capture 2D ou 3D de l'espace d'observation.

16. Dispositif d'affichage selon l'une des revendications 1 à 15, **caractérisé en ce que** le panneau d'affichage TFT (18) est en saillie au-dessus de la couche de filtre couleur (44) au niveau d'au moins un tronçon de bord (64), et cette saillie forme la zone de bord (64) contiguë latéralement à la surface d'affichage (62), ou **en ce que** le panneau d'affichage (18) à panneau TFT présente entre autres des pixels (20, 22, 24) et des transistors (38, 40, 42) réalisés selon la technologie de couche mince qui représentent conjointement la surface d'affichage (62) de l'unité d'affichage (11), et le panneau d'affichage TFT (18) fait saillie au-dessus la surface d'affichage (62) au niveau d'au moins un tronçon de bord (64), et cette saillie forme la zone de bord (64) contiguë latéralement à la surface d'affichage (62).
